# EUROPÄISCHE PATENTANMELDUNG

(11) **EP 3 267 338 A1**
(43) Veröffentlichungstag der Anmeldung: **10.01.2018**
(21) Anmeldenummer: 16178160.4
(22) Anmeldetag: 06.07.2016
(51) Int. Cl.: G06F 17/50

(54) **VERFAHREN ZUR BERECHNUNG VON KERBSPANNUNGEN IN EINER SCHWEISSNAHT**

(71) Anmelder: Siemens AG Österreich, 1210 Wien (AT)
(72) Erfinder: Kittinger, Bernhard, 8020 Graz (AT)
(74) Vertreter: Maier, Daniel Oliver

(57) **Zusammenfassung**

Verfahren, durchgeführt mittels eines Computers, zur Berechnung von Kerbspannungen (σ_{K}) an einem zu bewertenden Querschnitt eines zumindest eine Schweißnaht (2) aufweisenden Bauteils (1),
wobei in dem zu bewertenden Querschnitt (4) zumindest eine lokale Kerbe und/oder Wurzelkerbe der zumindest einen Schweißnaht (2) durch einen nach dem Kerbspannungskonzept ausgewählten Kerb-Radius (3) modelliert wird,
wobei der zu bewertende Querschnitt (4) mit einer definierten Last beaufschlagt ist.

Erfindungsgemäß ist dabei vorgesehen, dass ein von zumindest einer normierten Einheitslast (E_{1,...,}E_{n;} E_{X}) abhängiges Sub-Modell verwendet wird, wobei zur Erstellung des Sub-Modells die Inertia-Relief Methode verwendet wird, um Einheits-Teil-Kerbspannungen (σ_{TE}(E_{X})) aufgrund der Einheitslasten (E_{X}) zu berechnen und dass die Kerbspannungen (σ_{K}) aufgrund des tatsächlich vorherrschenden Belastungszustands des zu bewertenden Querschnitts (4) durch Linearkombination und Superposition der Einheits-Teil-Kerbspannungen (σ_{TE} (E₁) , ..., σ_{TE} (Eₙ) ; O_{TE} (E_{X}) ) berechnet werden, um eine exakte Berechnung der Kerbspannungen (σ_{K}) zu ermöglichen, ohne dass dafür Annahmen über die Randbedingungen getroffen werden müssen.

## Beschreibung

### Technisches Gebiet

Die Erfindung betrifft ein Verfahren, durchgeführt mittels eines Computers, zur Berechnung von Kerbspannungen an einem zu bewertenden Querschnitt eines zumindest eine Schweißnaht aufweisenden Bauteils, wobei in dem zu bewertenden Querschnitt zumindest eine lokale Kerbe und/oder Wurzelkerbe der zumindest einen Schweißnaht durch einen nach dem Kerbspannungskonzept ausgewählten Kerb-Radius modelliert wird, wobei der zu bewertende Querschnitt mit einer definierten Last beaufschlagt ist, sowie ein Computerprogrammprodukt zur Durchführung des Verfahrens.

### Stand der Technik

Bei der Dimensionierung und Konstruktion eines eine Schweißnaht oder mehrere Schweißnähte aufweisenden Bauteils, wobei die Schweißnaht in der Regel mehrere Komponenten des Bauteils fügetechnisch miteinander verbindet, sind Parameter wie Schweißnaht-Typ oder Schweißnaht-Querschnitt, genauso relevant wie die relative Position der Komponenten des Bauteils zueinander. Damit die Schweißnaht den im Betrieb wirkenden äußeren Lasten einerseits bei Spitzenbelastungen standhält und andererseits auch anhaltenden Belastungen über einen langen Zeitraum standhält, müssen neben den oben genannten Faktoren auch die Art der Krafteinwirkung, der Punkt bzw. die Fläche des Kraftangriffs und der Verlauf der Schweißnaht berücksichtigt werden.

Die modernste Methode zur Bewertung der Ermüdungsfestigkeit der Schweißnaht ist das Kerbspannungskonzept. Zur Anwendung dieses Kerbspannungskonzepts wird ein zu bewertender Querschnitt des Bauteils üblicher Weise unabhängig von der tatsächlichen Anzahl der Komponenten so modelliert, dass er einstückig ausgebildet ist und auch die Schweißnaht selbst mitumfasst, wobei die lokalen Kerben an den Nahtübergängen und Wurzeln der Schweißnaht bzw. der Schweißnähte durch einen normierten Kerb-Radius modelliert bzw. abgebildet werden. Der Bewertung der Ermüdungsfestigkeit werden sodann die berechneten Kerbspannungen an potentiellen Riss-Ausgangsorten am Grund des Kerb-Radius zu Grunde gelegt.

Zur Auslegung von Schweiß-Bauteilen werden in der Regel computergestützte Berechnungen mittels Finite-Elemente-Methoden (FEM) durchgeführt, in denen in an sich bekannter Art und Weise ein zweidimensionales oder dreidimensionales Gitternetz des Bauteils bzw. des zu bewertenden Querschnitts erzeugt wird und mit einer definierten Last belastet wird. Aus diesem Gitternetz werden dann durch den physikalischen Zusammenhang zwischen Verschiebung und Spannung, etwa implementiert durch eine Steifigkeitsmatrix, die Spannungen in den Knotenpunkten des Gitternetzes über die Verschiebung der Knotenpunkte unter Einwirkung der äußeren Last berechnet. Auf die technischen Einzelheiten der Berechnung soll in der Folge nicht näher eingegangen werden, da es sich bei der FEM-Berechnung um ein dem Fachmann geläufiges Verfahren handelt.

Die Berechnung der Kerbspannungen im zu bewertenden Querschnitt kann also über ein FEM-Modell erfolgen, welches nach den allgemeinen Grundsätzen der FEM-Berechnung unter Einbeziehung der Anforderungen des Kerbspannungskonzepts, meist computergeneriert, erzeugt wird. Die Funktion herkömmlicher Berechnungsverfahren für die Bestimmung von Kerbspannungen kann wie folgt dargestellt werden: Sowohl die Bauteilgeometrie, also die Zusammensetzung der einzelnen Komponenten des Bauteils, als auch der Verlauf der Schweißnaht sind in der Regel als komplex anzusehen. Durch die auf den zu bewertenden Querschnitt wirkende Last, die beispielsweise von den im Betrieb am Bauteil angreifenden Kräften verursacht werden kann, treten komplexe Kraftflüsse im zu bewertenden Querschnitt auf, die bei der Kerbspannungsberechnung berücksichtigt werden müssen. Zur Berechnung der Kerbspannung im zu bewertenden Querschnitt, beispielsweise an einem Schnittufer, sind neben der auf den Querschnitt wirkenden Last, also beispielsweise den im Betriebszustand angreifenden Zug-, Quer- oder Druckkräften bzw. Biegemomenten, auch Randbedingungen festzulegen, an denen sich bei der Berechnung Reaktionskräfte ergeben die in der Regel einen Gleichgewichtszustand ausbilden, um die zur Berechnung notwendige Verschiebung berechnen zu können.

Die Festlegung dieser Randbedingungen hat jedoch einen großen Einfluss auf den Kraftfluss durch den zu bewertenden Querschnitt, der der Spannungsberechnung zugrunde liegt. Ein Nachteil des Berechnungsverfahrens nach dem Stand der Technik äußert sich nun darin, dass der Benutzer des Berechnungsverfahrens Annahmen über den sich im zu bewertenden Querschnitt unter der äußeren Last einstellenden Kraftfluss treffen muss und die Randbedingungen entsprechend auswählen muss. Dies führt einerseits zu Berechnungsfehlern durch schlecht gewählte Randbedingungen aufgrund nicht zutreffender Annahmen über den tatsächlichen Kraftfluss, andererseits ist auch die Modellierungsmöglichkeit über die gewählten Randbedingungen begrenzt, da sich komplexe Belastungssituationen nicht exakt über die idealisierten Randbedingungen darstellen lassen.

### Aufgabe der Erfindung

Es ist daher eine Aufgabe der Erfindung die Nachteile des Stands der Technik zu überwinden und ein computergestütztes Verfahren zur Berechnung von Kerbspannungen an einem zu bewertenden Querschnitt eines zumindest eine Schweißnaht aufweisenden Bauteils vorzuschlagen, welches eine Berechnung der Kerbspannung ermöglicht, ohne dass Annahmen über die Randbedingungen getroffen werden müssen. Eine weitere Aufgabe liegt darin, die Qualität der berechneten Ergebnisse zu erhöhen und systemimmanente Berechnungsfehler zu vermeiden. Auch soll die Erfindung die Berechnung von einer beliebigen Anzahl an Lastfällen für eine beliebige Anzahl an zu bewertenden Querschnitten in einer wirtschaftlichen Art und Weise ermöglichen.

### Darstellung der Erfindung

Zumindest eine dieser Aufgabe wird durch ein erfindungsgemäßes, mittels eines Computers durchgeführten Verfahren zur Berechnung von Kerbspannungen an einem zu bewertenden Querschnitt eines zumindest eine Schweißnaht aufweisenden Bauteils mit den Merkmalen des Patentanspruchs 1 gelöst. Vorteilhafte Ausgestaltungen der Erfindung sind in den jeweiligen abhängigen Ansprüchen definiert.

Die Erfindung betrifft ein Verfahren, durchgeführt mittels eines Computers, zur Berechnung von Kerbspannungen an einem zu bewertenden Querschnitt eines zumindest eine Schweißnaht aufweisenden Bauteils, wobei in dem zu bewertenden Querschnitt zumindest eine lokale Kerbe und/oder Wurzelkerbe der zumindest einen Schweißnaht durch einen nach dem Kerbspannungskonzept ausgewählten Kerb-Radius modelliert wird, wobei der zu bewertende Querschnitt mit einer definierten Last beaufschlagt ist.

Das erfindungsgemäße Verfahren stützt sich dabei bei der Berechnung der Kerbspannung auf die Anwendung der Inertia-Relief Methode, bei der keine explizite Definition von Randbedingungen durch den Anwender notwendig ist. Es werden also keine Reaktionskräfte an definierten Stellen des Querschnitts berechnet, sondern es wird ein Beschleunigungsfeld ermittelt, welches die Reaktion des zu bewertenden Querschnitts auf die definierte Last darstellt. Auf die genaue Implementierung des Verfahrens wird in der Folge näher eingegangen.

Ein weiterer Aspekt der Erfindung liegt in einer wirtschaftlichen Reproduzierbarkeit von einer Vielzahl an Berechnungen an einem zu bewertenden Querschnitt. Dies ist notwendig, da für die Bewertung der Ermüdungsfestigkeit in der Regel für ein gesamtes Lastkollektiv, also für eine Vielzahl an unterschiedlichen Lastfällen, wobei in jedem Lastfall eine betrags- und oder richtungsmäßig unterschiedliche Last auf den zu bewertenden Querschnitt wirken kann, die entsprechenden Kerbspannungen berechnet werden müssen, um eine Bewertung der Ermüdungsfestigkeit zu ermöglichen.

Erfindungsgemäß wird daher ein Sub-Modell verwendet, welches unabhängig von der tatsächlich auf den zu bewertenden Querschnitt wirkenden Last berechnet wird. Anstatt der tatsächlichen Last wird zumindest eine normierte Einheitslast der Erstellung des Sub-Modells zu Grunde gelegt. Bei dieser Einheitslast kann es sich sowohl um eine Kraft als auch um ein Moment handeln, wobei der Betrag der Einheitslast vorzugsweise einer ganzzahligen Potenz der Basiszahl zehn entspricht. Es versteht sich jedoch von selbst, dass der Betrag der Einheitslast beliebig groß gewählt sein kann, wie nachfolgend erläutert.

Zur Erstellung des Sub-Modells wird nun der zu bewertende Querschnitt mit der ersten Einheitslast belastet und mittels der Inertia-Relief Methode die Systemantwort des zu bewertenden Querschnitts auf die erste Einheitslast in Form des ersten Beschleunigungsfelds bestimmt. In einfachen Worten ausgedrückt wird dabei der zu bewertende Querschnitt nicht wie bei einem herkömmlichen FEM-Berechnungsverfahren "festgehalten", sodass die Verschiebungen der einzelnen Knotenpunkte bestimmt werden können, sondern es wird ein Beschleunigungsfeld berechnet, mit dem der zu bewertende Querschnitt beaufschlagt wird, sodass die aus der Beschleunigung resultierende Kraft (die sich nach der Newton'schen Beziehung als Kraft gleich Masse mal Beschleunigung ergibt) mit der ersten Einheitslast im Gleichgewicht steht. Der zu bewertende Querschnitt steht also nicht im statischen oder quasi statischen Gleichgewicht sondern wird einer ununterbrochenen Beschleunigung unterzogen. Mittels der Inertia-Relief Methode lassen sich aus dem dynamischen Gleichgewichts-Zustand des ersten Beschleunigungsfeldes und der Einheitslast Spannungen im zu bewertenden Querschnitt berechnen. Dementsprechend lässt sich auch die, aus der Belastung des zu bewertenden Querschnitts mit der Einheitslast resultierende, Kerbspannung berechnen, die in der Folge als Einheits-Teil-Kerbspannung aufgrund der ersten Einheitslast, oder in mathematischer Weise dargestellt σ_{TE}(E₁), bezeichnet wird. Diese erste Einheits-Teil-Kerbspannung σ_{TE}(E₁) kann mittels der Inertia-Relief Methode exakt und analytisch bestimmt werden, sodass der Kraftfluss aufgrund der ersten Einheitslast durch den zu bewertenden Querschnitt, ohne etwaige Annahmen treffen zu müssen, dem tatsächlich durch die Einheitslast bedingten Kraftfluss-Komponente entspricht.

Umfasst das Sub-Modell nur eine normierte Einheitslast, so ist die Erstellung bereits abgeschlossen. In der praktischen Anwendung sind mehrere verschieden gerichtete und/oder verschieden geartete Einheitslasten erforderlich, um einen allgemeinen Belastungszustand darzustellen, daher wird der zuvor beschriebene Berechnungsvorgang für jede weitere normierte Einheitslast wiederholt, wobei jeweils immer nur die Systemantwort auf eine einzige Einheitslast berechnet wird. Am Ende der Berechnung steht immer eine Einheits-Teil-Kerbspannung aufgrund einer bestimmten Einheitslast oder in mathematischer Weise dargestellt σ_{TE}(E_{X}). Dabei steht der Index "X" für eine spezielle Einheitslast die aus der Gruppe der Einheitslasten ausgewählt ist. Der Wert für den Index "X" liegt dabei also zwischen 1, für die erste Einheitslast, und n, für die letzte Einheitslast. Diese Nomenklatur wir in der Folge auch im Zusammenhang mit den Kerbspannungen weiterverwendet.

Dieser Vorgang wird für alle Einheitslasten wiederholt, wobei der Index "X" sich schrittweise für jeden Berechnungsdurchgang erhöht, bis für alle Einheitslasten E₁,...,Eₙ die entsprechenden Einheits-Teil-Kerbspannungen σ_{TE}(E₁),...,σ_{TE}(Eₙ) berechnet sind. Sobald alle Einheits-Teil-Kerbspannungen berechnet sind, ist das Sub-Modell, welches alle Einheits-Teil-Kerbspannungen umfasst, erstellt.

Auf der Grundlage des Sub-Modells kann nachfolgend die tatsächliche Kerbspannung σ_{K}, die tatsächlich durch die definierte auf den zu bewertenden Querschnitt wirkende Last hervorgerufen wird, in erfindungsgemäßer Art und Weise schnell und wirtschaftlich berechnet werden. Das Berechnungsverfahren umfasst dabei die folgenden Schritte:
Um die berechneten Einheits-Teil-Kerbspannungen σ_{TE}(E₁),...,σ_{TE}(Eₙ) aus dem Submodell verwenden zu können, wird der durch die Last in dem zu bewertenden Querschnitt vorherrschende Belastungszustand, also in anderen Worten die am zu bewertenden Querschnitt angreifenden Kräfte und/oder Momente, als Linearkombination der Einheitslasten dargestellt. So lässt sich in einem zweidimensionalen Modell eine allgemeine am zu bewertenden Querschnitt angreifende Last als Linearkombination von drei normierten Einheitslasten, insbesondere je Schnittufer, darstellen, wobei die drei Einheitslasten jeweils 2 Kräfte und 1 Biegemoment umfassen. Durch die entsprechende Berechnung von Linearkombinations-Faktoren für jede Einheitslast, lässt sich der Belastungszustand als Linearkombination der Einheitslasten darstellen, sodass die Summe der Produkte jeweils eines berechneten Linearkombinations-Faktors mit einer Einheitslast für alle Einheitslasten dem tatsächlichen Belastungszustand entspricht. Anhand eines einfachen Beispiels erklärt, berechnet sich für einen zu bewertenden Querschnitt mit einer als Einheitskraft ausgebildeten Einheitslast mit dem Betrag 0,5 N und einer in derselben Wirklinie zur Einheitskraft wirkenden als Schnittkraft ausgebildeten Last von 8 N ein Linearkombinations-Faktor n₁ von 8 N/0,5 N gleich 16. In analoger Art und Weise lassen sich entsprechend auch Lasten im zweidimensionalen und dreidimensionalen Raum aufteilen.

Sobald die Linearkombinations-Faktoren für den gesamten Belastungszustand bestimmt sind, werden auf Basis der im Sub-Modell vorhandenen Einheits-Teil-Kerbspannungen aufgrund der Einheitslast σ_{TE}(E₁),...,σ_{TE}(Eₙ) Teil-Kerbspannungen, oder in mathematischer Weise ausgedrückt σ_{T}, berechnet, indem die Linearkombinations-Faktoren mit der Einheits-Teil-Kerbspannung der dem Linearkombinations-Faktor zugehörigen Einheitslast multipliziert werden. Anhand des zuvor genannten Beispiels erläutert, berechnet sich die Teil-Kerbspannung σ_{T1} aus der Multiplikation des Linearkombinations-Faktors n₁ mit der Einheits-Teil-Kerbspannung σ_{TE}(E₁). Dieses Verfahren wird so oft wiederholt, bis alle bestimmten Linearkombinations-Faktoren in Teil-Kerbspannungen umgerechnet sind.

Es versteht sich dabei von selbst, dass es mathematisch gesehen keinen Unterschied macht, ob zuerst alle Linearkombinations-Faktoren bestimmt werden und danach alle Teil-Kerbspannungen berechnet werden oder ob für jeden Linearkombinations-Faktor oder für einzelne durch Linearkombinations-Faktoren dargestellte unterschiedliche Kräfte und/oder Momente des Belastungszustands unmittelbar die entsprechenden Teil-Kerbspannungen berechnet werden. Gleichermaßen können auch die Linearkombinations-Faktoren für eine Einheitslast die Komponenten verschiedener Kräfte und/oder verschiedener Momente enthält in einem kombinierten Linearkombinations-Faktor zusammengefasst werden.

Um das Endergebnis der Berechnung, also die Kerbspannungen in dem zu bewertenden Querschnitt aufgrund der auf den Querschnitt wirkenden Belastung zu erhalten, werden im letzten Schritt des Verfahrens die einzelnen Teil-Kerbspannungen mittels linearer Superposition addiert. Es soll in diesem Zusammenhang nicht unerwähnt bleiben, dass die Einheits-Teil-Kerbspannungen für sich genommen keine Aussagekraft über die tatsächlich vorliegende Kerbspannung im Lastfall haben. Erst durch die Superposition der Teil-Kerbspannungen wird der Einfluss der den Belastungszustand definierenden Last auf den zu bewertenden Querschnitt tatsächlich dargestellt. Mit anderen Worten wird der tatsächlich im zu bewertenden Querschnitt vorliegende Kraftfluss erst dann durch das Berechnungsergebnis widergespiegelt, wenn die gesamte definierte Last durch die Superposition der Teil-Kerbspannungen berücksichtigt ist. Im Falle einer quasistatischen Belastungs-Situation stehen die die definierte Last ausbildenden Kräfte und/oder Momente im Gleichgewicht. Für den Fall, dass die definierte Last auch Beschleunigungen beinhaltet, stehen die übrigen Kräfte und/oder Momente der Last mit den Beschleunigungen im Gleichgewicht (dynamisches Gleichgewicht: Kraft gleich Masse mal Beschleunigung).

Unter dem Begriff Einheits-Teil-Kerbspannung ist nicht zwangsläufig ein einzelner Wert zu verstehen, sondern ist auch ein Vektor, ein Tensor oder eine, vorzugsweise mehrdimensionale, Matrix, vorzugsweise mit einem Tensor oder einem Vektor für einen oder mehrere Knotenpunkte eines Gitternetzes, zu verstehen. Analoges gilt natürlich auch für die Teil-Kerbspannungen und die Kerbspannung selbst. Umfasst der zu bewertende Querschnitt zwei, drei oder mehr Schweißnähte, so können auch Einheits-Teil-Kerbspannung, Teil-Kerbspannung und Kerbspannung entsprechende Werte, Vektoren, Tensoren oder Matrizen für jede erforderliche Stelle der Schweißnähte umfassen, an denen später eine Bewertung der Kerbspannung durchgeführt werden soll. Insbesondere ist in der Kerbspannung ein Spannungstensor für zumindest einen im Kerb-Radius einer Schweißnaht enthaltenen Knotenpunkt enthalten. Vorzugsweise ist eine Vielzahl, besonders bevorzugt alle, den Kerb-Radius ausbildenden Knotenpunkte jeder Schweißnaht von der berechneten Kerbspannung umfasst.

Die Vorteile des erfindungsgemäßen Verfahrens stellen sich dabei wie folgt dar: Da die Einheits-Teil-Kerbspannungen mittels der Inertia-Relief Methode berechnet werden und den jeweils durch eine der Einheitslasten bewirkten Kraftfluss durch den zu bewertenden Querschnitt repräsentieren, spiegelt die Superposition der Linearkombinationen der Teil-Kerbspannungen den tatsächlichen, durch die definierte Last bewirkten Kraftfluss durch den zu bewertenden Querschnitt wieder. Bei keiner der Berechnungen ist es notwendig eine Annahme über die Randbedingungen treffen zu müssen, sodass die berechnete Kerbspannung keinerlei durch eine Annahme bedingte Fehler aufweist. Mit anderen Worten handelt es sich bei dem Ergebnis des erfindungsgemäßen Berechnungsverfahrens um eine analytisch exakte Lösung des mechanischen Problems.

Ein weiterer Vorteil des erfindungsgemäßen Verfahrens liegt in der Erstellung des Sub-Modells: Dadurch, dass das Sub-Modell auf Basis der Einheitslasten erstellt wird und damit die tatsächlich auf den zu bewertenden Querschnitt wirkende Last, weder nach Art, Richtung oder Betrag in die Erstellung des Sub-Modells einbezogen ist, können die berechneten Einheits-Teil-Kerbspannungen eines Submodells als Basis für eine Vielzahl an unterschiedlichen Lastfällen mit entsprechenden unterschiedlichen definierten Lasten herangezogen werden. Dabei erfolgt die mathematisch komplexe und rechenintensive Bestimmung der Einheits-Teil-Kerbspannungen nur einmal bei der Erstellung des Sub-Modells. Zur Berechnung der Kerbspannung aufgrund eines tatsächlichen Lastfalles mit einer konkreten definierten Last kann auf die bereits berechneten Einheits-Teil-Kerbspannungen des Sub-Modells zurückgegriffen werden, wobei nur mehr die Linearkombination und die Superposition berechnet werden müssen. Sowohl die Linearkombination als auch die Superposition stellen dabei sehr einfache und wenig komplexe Berechnungsverfahren dar, die wenig Rechenkapazität benötigen und daher schnell und wirtschaftlich abgewickelt werden können. Somit lässt sich nach der Erstellung des Sub-Modells für einen zu bewertenden Querschnitt die Kerbspannung für eine große Anzahl unterschiedlicher Lastfälle mit in Art, Richtung und Betrag verschiedenen definierten Lasten schnell und kostengünstig, in Bezug zu der benötigten Rechenleistung, berechnen.

Gemäß einer Ausführungsvariante der Erfindung ist vorgesehen, dass der zu bewertende Querschnitt zur Erstellung des Sub-Modells und/oder zur Berechnung der Kerbspannungen als Querschnittsmodell abgebildet wird, vorzugsweise mittels eines FEM-, Finite Elemente Methoden, Verfahrens. Ein derartiges Querschnittsmodell kann beispielsweise über ein CAD, Computer Aided Design, Programm erstellt werden und etwa dreidimensional oder zweidimensional ausgebildet sein. Durch die Modellierung des zu bewertenden Querschnitts wird die Berechnung der Einheits-Teil-Kerbspannungen vereinfacht. Besonders gut eignen sich beispielsweise aus den CAD-Modellen abgeleitete FEM-Modelle, in dem der zu bewertende Querschnitt mittels eines Netzes aus miteinander verbundenen Knotenpunkten abgebildet ist. Durch die Verschiebung der Knotenpunkte unter Berücksichtigung einer Steifigkeitsmatrix können so in einfacher Art und Weise die Einheits-Teil-Kerbspannungen berechnet werden.

Es versteht sich dabei von selbst, dass die im Sub-Modell enthaltenen Einheits-Teil-Kerbspannungen sowohl einen Spannungstensor für einen Knotenpunkt oder mehrere Spannungstensoren für mehrere Knotenpunkte, beispielsweise in Form einer mehrdimensionalen Matrix, umfassen können. Gleichermaßen kann die Einheits-Teil-Kerbspannung auch in Form eines Skalars für einen Knotenpunkt oder in Form mehrerer Skalare für unterschiedliche Knotenpunkte berechnet sein. Die Einheits-Teil-Kerbspannungen verstehen sich also nicht zwangsläufig als ein betragsmäßig festgelegter Wert sondern können, je nach Ausbildung des Querschnittsmodells, als ein Skalar, ein Vektor, ein Tensor oder eine Gruppe von Vektoren oder eine Gruppe von Tensoren verstanden werden.

Üblicher Weise wird zur Berechnung der Kerbspannungen der zu bewertende Querschnitt, der abhängig von seiner Position im Bauteil in seiner Form variabel sein kann, freigeschnitten, sodass gemäß dem dritten Newton'schen Gesetz die Reaktionskräfte im Bauteil an den Schnittufern sichtbar werden, an denen der Bauteil virtuell geschnitten wird. In der Regel sind dabei zumindest zwei Schnitte notwendig, sodass die Reaktionskräfte, besser Schnittlasten, an zumindest zwei Schnittufern sichtbar werden. Beispielsweise kann dieser frei geschnittene Abschnitt durch ein Querschnittsmodell nachgebildet sein. Der durch die definierte Last auf den zu bewertenden Querschnitt einwirkende Belastungszustand manifestiert sich dadurch als an den zumindest zwei Schnittufern angreifende Schnittlasten. Diese Schnittlasten bedingen damit die Kerbspannung im zu bewertenden Querschnitt. Unter Schnittlast ist in diesem Zusammenhang sowohl eine Schnittkraft, wie Normalkraft oder Querkraft, als auch ein Schnittmoment, wie ein Biegemoment oder ein Torsionsmoment, zu verstehen.

Daher ist in einer weiteren Ausführungsvariante der Erfindung vorgesehen, dass der Belastungszustand des zu bewertenden Querschnitts durch an zumindest zwei Schnittufern angreifende Schnittlasten dargestellt wird.

Um sicherzustellen, dass die Kerbspannungen für den aus der definierten Last resultierenden Belastungszustand mittels des Sub-Modells berechnet werden können, ist in einer weiteren Ausführungsvariante des erfindungsgemäßen Verfahrens vorgesehen, dass die Art, Richtung und Anzahl der normierten Einheitslasten derart gewählt ist, dass sich zumindest die angreifenden Schnittlasten als Linearkombination der Einheitslasten darstellen lassen. In einem allgemeinen zweidimensionalen Belastungszustand, in dem beispielsweise eine oder mehrere unterschiedlich gerichtete Schnittkräfte und ein oder mehrere unterschiedliche Schnittmomente an den Schnittufern angreifen, sind in der Regel zumindest zwei als linear unabhängige Einheitskräfte ausgebildete Einheitslasten und eine als Einheitsmoment ausgebildete Einheitslast, vorzugsweise pro Schnittufer, notwendig, um den allgemeinen Belastungszustand als Linearkombination der Einheitslasten darstellen zu können. Auch für dreidimensionale angreifende Schnittkräfte lässt sich diese Aufteilung analog mit drei linear unabhängigen Einheitskräften und drei linear unabhängigen Einheitsmomenten, vorzugsweise pro Schnittufer, bewerkstelligen.

Damit die in einem Sub-Modell enthaltenen Einheits-Teil-Kerbspannungen aufgrund der Einheitslasten universell als Basis für die Berechnung einer Vielzahl an verschiedenen Lastfällen, beispielsweise für unterschiedlichste Schnittlasten, verwendet werden können, sieht eine weitere Ausführungsvariante der Erfindung vor, dass die normierten Einheitslasten als linear unabhängige Einheitskräfte und/oder linear unabhängige Einheitsmomente ausgebildet sind, sodass beliebige Lastzustände als Linearkombination der normierten Einheitslasten darstellbar sind. Für eine solche Darstellbarkeit ist es notwendig, das die Einheitskräfte und die Einheitsmomente ein Koordinatensystem aufspannen mittels welchem jede Schnittlast in einzelne Komponenten in den Richtungen des durch die Einheitslasten definierten Koordinatensystems aufgeteilt werden kann. Vorzugsweise sind für jedes Schnittufer ein eigenes Koordinatensystem und dieses aufspannende Einheitslasten vorgesehen. Dadurch, dass die Einheitskräfte und/oder die Einheitsmomente linear unabhängig voneinander sind, wird erreicht, dass sich jede Kraft bzw. jedes Moment durch eine Linearkombination der Einheitslasten darstellen lässt. Für einen allgemeinen zweidimensionalen Belastungszustand sind dafür zwei Einheitskräfte und ein Einheitsmoment notwendig, für einen allgemeinen dreidimensionalen Belastungszustand drei Einheitskräfte und drei Einheitsmomente. Besonders bevorzugt spannen die Einheitskräfte und/oder die Einheitsmomente ein orthogonales Koordinatensystem auf, um die Berechnung der Einheits-Teil-Kerbspannungen zu vereinfachen.

Eine Ausführungsvariante der Erfindung sieht vor, dass der zu bewertende Querschnitt normal zur Verlaufsrichtung der zumindest einen Schweißnaht im Bauteil ausgerichtet ist. Durch die Wahl einer Schnittebene mit der der zu bewertende Querschnitt freigeschnitten wird, die normal auf die Verlaufsrichtung der Schweißnaht steht, wird sichergestellt, dass die geometrische Form des zu bewertenden Querschnitts korrekt dargestellt ist und der Realität entspricht. Somit ist der Kerb-Radius bzw. sind die Kerb-Radien unverzerrt dargestellt, sodass den berechneten Kerbspannungen eine hohe Aussagekraft zukommt.

Gemäß einer bevorzugten Ausführungsvariante des erfindungsgemäßen Berechnungsverfahrens ist vorgesehen, dass das, insbesondere die Einheits-Teil-Kerbspannungen aufgrund der einzelnen Einheitslasten umfassende, Sub-Modell nach der Erstellung in einem nicht temporären Speicher gespeichert wird. Somit kann sichergestellt werden, dass die auf Basis der Inertia-Relief Methode berechneten Einheits-Teil-Kerbspannungen nicht nach Beendigung der Berechnung gelöscht werden bzw. für weitere Berechnungen wiederverwendbar sind.

Um die gespeicherten Sub-Modelle für eine spätere Wiederbenutzung voneinander unterscheidbar zu machen, ist in einer weiteren bevorzugten Ausführungsvariante vorgesehen, dass das Sub-Modell Querschnitts-Geometrie-Daten zur Identifikation des Sub-Modells umfasst. Besonders vorteilhaft ist es dabei, wenn die Querschnitts-Geometrie-Daten zumindest eine der folgenden, für den zu bewertenden Querschnitt charakteristischen, Informationen enthalten:
Anzahl der einzelnen den zu bewertenden Querschnitt ausbildenden Komponenten, relative Position der Komponenten zueinander, Dicke der einzelnen Komponenten, Position der zumindest einen Schweißnaht im zu bewertenden Querschnitt, Schweißnaht-Typ und/oder Schweißnaht-Querschnitt der jeweiligen Schweißnaht. Es versteht sich dabei von selbst, dass für eine eindeutige Identifizierbarkeit eines Submodells für einen spezifischen zu bewertenden Querschnitt unter einer Vielzahl von Submodellen, jedes der Sub-Modelle mehrere, vorzugsweise alle, der oben angegebenen Informationen als Querschnitts-Geometrie-Daten aufweisen sollten. Desto mehr Informationen in den Querschnitts-Geometrie-Daten im Submodell enthalten sind, wobei eine beliebige Kombination der genannten Informationen denkbar ist, desto genauer lässt sich der zu bewertende Querschnitt identifizieren.

In einer weiteren bevorzugten Ausführungsvariante der Erfindung ist vorgesehen, dass vor der Erstellung eines neuen Sub-Modells für einen zu bewertenden Querschnitt überprüft wird, ob eines der im Speicher gespeicherten Sub-Modelle dieselben Querschnitts-Geometrie-Daten aufweist wie der zu bewertende Querschnitt des zu erstellenden Sub-Modells. Mittels dieser Überprüfung ist es möglich, eine erneute Erstellung des Sub-Modells gegebenenfalls zu vermeiden. Dies ist insbesondere von Bedeutung, da die Erstellung des Sub-Modells den rechenintensiveren und aufwändigeren Prozess darstellt.

So kann in einer weiteren bevorzugten Ausführungsvariante vorgesehen sein, dass das Sub-Modell erstellt wird, wenn die Überprüfung des Speichers kein Ergebnis liefert. Da eine Berechnung der Kerbspannung ohne passendes Sub-Modell für den zu bewertenden Querschnitt nicht möglich ist, muss in diesem Fall ein Sub-Modell nach den erfindungsgemäßen Schritten erstellt werden.

Wenn jedoch die Überprüfung ergeben hat, dass die Querschnitts-Geometrie-Daten eines gespeicherten Sub-Modells den Querschnitts-Geometrie-Daten des aktuell zu bewertenden Querschnitts entsprechen, so muss das Sub-Modell nicht ein weiteres Mal erstellt werden, sondern es kann das Sub-Modell aus dem Speicher geladen und zur Berechnung der Kerbspannung aufgrund der aktuellen Last verwendet werden. So lässt sich die Anzahl an rechenintensiven Schritten deutlich reduzieren, da nicht für jede Kerbspannungsberechnung ein neues Sub-Modell erstellt werden muss.

Um die Integrität der berechneten Kerbspannung zu sichern und etwaige Eingabefehler oder Fehler bei der Modellbildung ausschließen zu können, ist in einer weiteren Ausführungsvariant der Erfindung vorgesehen, dass vor der Berechnung der Teil-Kerbspannungen oder vor Ausgabe der berechneten Kerbspannung eine Plausibilitätsüberprüfung durchgeführt wird und eine Meldung generiert wird, falls die Plausibilitätsprüfung fehlschlägt. Diese Meldung kann beispielsweise als Warnhinweis über ein Userinterface, insbesondere eine grafische Benutzeroberfläche, wiedergegeben werden, um einen Benutzer auf das nicht plausible Berechnungsergebnis hinzuweisen. Gleichzeitig kann der Berechnungsvorgang unterbrochen werden, sobald die Plausibilitätsüberprüfung fehlschlägt. Beispielsweise kann eine Obergrenze für die Schnittlasten definiert sein und bei der Plausibilitätsprüfung überprüft werden ob die Schnittlasten unterhalb der definierten Obergrenze liegen. Gleichermaßen kann auch eine Obergrenze für die Kerbspannung festgelegt sein und überprüft werden ob die berechnete Kerbspannung unterhalb der definierten Obergrenze liegt.

Eine weitere bevorzugte Ausführungsvariante sieht vor, dass zur Plausibilitätsprüfung überprüft wird, ob sich die aus der Linearkombination der Einheitslasten resultierenden Lasten am zu bewertenden Querschnitt in einem Gleichgewichtszustand befinden. Nur wenn sich ein Gleichgewichtszustand einstellt, entspricht der der berechneten Kerbspannung zugrunde liegende Kraftfluss dem realen Kraftfluss durch den zu bewertenden Querschnitt. Wird also zur Plausibilitätsprüfung das Gleichgewichtskriterium herangezogen, so kann implizit die Richtigkeit des der Berechnung zugrunde liegenden Kraftflusses sichergestellt werden. Gleichermaßen kann überprüft werden, ob die Linearkombinationsfaktoren korrekt berechnet worden sind und der Belastungszustand richtig durch die Linearkombination der Einheitslasten abgebildet wurde.

In einer besonders bevorzugten Ausführungsvariante des erfindungsgemäßen Verfahrens ist vorgesehen, dass das erfindungsgemäße Verfahren zur Bewertung der Ermüdungsfestigkeit von Schweißnähten nach dem Kerbspannungskonzept eingesetzt wird, wobei Kerbspannungen für eine Vielzahl an unterschiedlichen Belastungszuständen, vorzugsweise mit betragsmäßig und/oder richtungsmäßig unterschiedlichen Schnittlasten, am zu bewertenden Querschnitt mittels des Sub-Modells ermittelt werden. Durch das erfindungsgemäße Berechnungsverfahren lässt sich mittels des einmal berechneten Sub-Modells schnell und einfach eine Kerbspannung für eine Vielzahl von unterschiedlichen Lastfällen berechnen. Beispielsweise lässt sich so in effizienter Art und Weise ein gesamtes Lastkollektiv für die Bewertung der Ermüdungsfestigkeit berechnen. Da sich durch die Bewertung der Kerbspannungen Rückschlusse auf mögliche Rissbildungen oder Ausgangsorte für Rissbildungen im zu bewertenden Querschnitt ziehen lassen, kann durch das Ergebnis der Bewertung der zu bewertende Bauschnitt und/oder der Bauteil und/oder die Schweißnaht konstruktiv angepasst werden. Insbesondere von Vorteil sind dabei die exakten Ergebnisse die durch die erfindungsgemäße Berechnung der Kerbspannung generiert werden, da eben keine vereinfachenden Annahmen über den Kraftfluss bzw. etwaige Randbedingungen getroffen werden müssen. Durch das Ergebnis der Bewertung lässt sich die Dimensionierung des Querschnitts bzw. die Konstruktion des Bauteils und der Schweißnaht optimieren, da nach dem Stand der Technik benötige Sicherheitsfaktoren für etwaige Berechnungsfehler aufgrund von unzutreffenden Annahmen nicht mehr oder nur in sehr geringem Umfang notwendig sind. Dadurch kann beispielsweise der Schweißnahtquerschnitt oder die Dicke bzw. Blechdicke der Komponenten des Bauteils, die den zu bewertenden Querschnitt ausbilden, reduziert werden, was zu Gewichtseinsparungen beim Bauteil und zu Einsparungen der Fertigungskosten des Bauteils führt.

In einer weiteren besonders bevorzugten Ausführungsvariante ist vorgesehen, dass die Kerbspannung eine tangentiale Spannungskomponente für einen am Kerb-Radius angeordneten Knotenpunkt des zu bewertenden Querschnittsaufweist oder dass eine tangentiale Spannungskomponente aus der Kerbspannung berechnet wird, wobei die tangentiale Spannungskomponente tangential zum Kerb-Radius ausgerichtet ist und dass die tangentiale Spannungskomponente für die Bewertung der Schweißnähte verwendet wird. Für die Bewertung der Kerbspannungen sind die Kerbspannungen in den den Kerb-Radius ausbildenden Knotenpunkten, beispielsweise des FEM-basierten Querschnittsmodells, des zu bewertenden Querschnitts von besonderer Bedeutung. Umfasst das Bauteil mehrere Schweißnähte, so sind die Kerbspannungen in den Knotenpunkten der Kerb-Radien jeder Schweißnaht relevant. Die tangentiale Spannungskomponente die im Knotenpunkt tangential zum Kerb-Radius steht, wird gemeinhin als "Kerbspannung" bezeichnet. Je nach Ausrichtung des Koordinatensystems kann es daher notwendig sein, dass der Spannungstensor im Knotenpunkt transformiert werden muss, um eine tangentiale Spannungskomponente aufzuweisen. Die tangentiale Spannungskomponente der Kerbspannung wird dann zur Bewertung der Schweißnähte nach dem Kerbspannungskonzept verwendet, wobei des Weiteren auch Längs- und Schubspannungen berücksichtigt werden müssen, die über andere Verfahren bestimmt werden.

Eine erfindungsgemäße Aufgabe wird auch durch ein Computerprogrammprodukt (z.B. in Form eines Datenträgers, eines Speichermediums oder eines Signals) gelöst, welches ein Programm umfasst und direkt in einen Speicher eines Rechners ladbar ist, mit Programm-Mitteln, um alle Schritte des erfindungsgemäßen Verfahrens auszuführen, wenn das Programm vom Rechner ausgeführt wird. Die Implementierung der Berechnungsschritte als Computerprogramm, welches insbesondere die Berechnung der Einheits-Teil-Kerbspannungen nach der Inertia-Relief Methode an einen oder mehrere, vorzugsweise leistungsstarke, Prozessorkerne auslagert, ist für die Geschwindigkeit der Berechnung und die Zuverlässigkeit der Ergebnisse von besonderem Vorteil. Insbesondere kann das Computerprogramm als Modul eines umfangreicheren Berechnungsprogramms, etwa eines FEM basierten Softwarepakets, ausgeführt sein, um Grundfunktionen, wie die Erstellung des FEM-Modells, des Berechnungsprogramms nützen zu können.

### Kurzbeschreibung der Figuren

Zur weiteren Erläuterung der Erfindung wird im nachfolgenden Teil der Beschreibung auf die Figuren Bezug genommen, aus der weitere vorteilhafte Ausgestaltungen, Einzelheiten und Weiterbildungen der Erfindung zu entnehmen sind. Die Figuren sind als beispielhaft zu verstehen und sollen den Erfindungscharakter zwar darlegen, ihn aber keinesfalls einengen oder gar abschließend wiedergeben. Es zeigten:
- Fig. 1: eine Ausführungsvariante eines zu bewertenden Querschnitts eines Bauteils;
- Fig. 2: eine schematische Darstellung zur Erläuterung des Einflusses der Randbedingungen;
- Fig. 3: eine Prinzipdarstellung der Inertia-Relief Methode.

### Ausführung der Erfindung

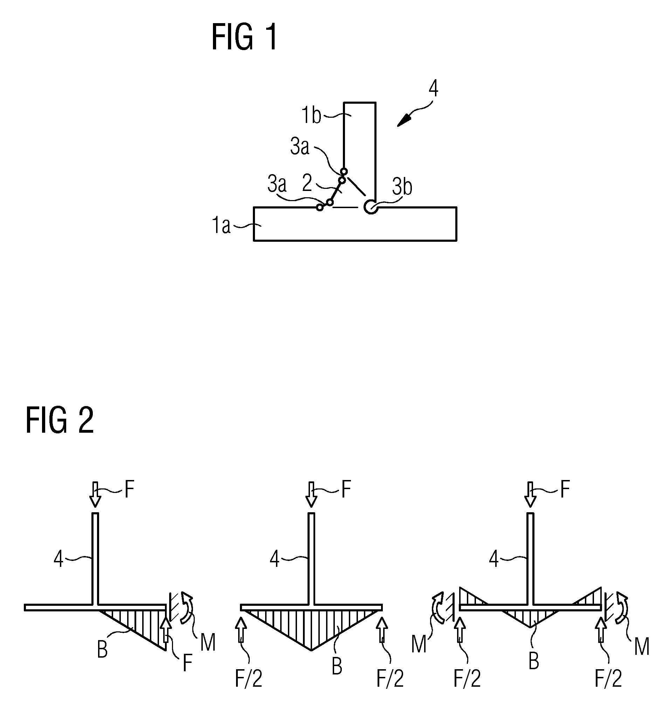

Figur 1 zeigt eine Ausführungsvariante eines zu bewertenden Querschnitts 4 eines Bauteils 1 mit einer Schweißnaht 2 an dem Kerbspannungen σ_{K} ermittelt werden sollen. Bei dem Bauteil 1 handelt es sich hier exemplarisch um zwei normal zueinander ausgerichtete Bleche 1a,1b, nämlich einem in der Abbildung horizontal ausgerichteten Gurtblech 1a und einem in der Abbildung vertikal ausgerichteten Stegblech 1b, die T-förmig angeordnet sind. Die beiden Bleche 1a,1b sind durch die Schweißnaht 2 miteinander verbunden. Der dargestellte zu bewertende Querschnitt 4 ist normal zur Längs-Richtung der Schweißnaht 2 im Bauteil 1 ausgerichtet, welche Längs-Richtung in der vorliegenden Abbildung aus der Bildebene hinausragt.

Durch die Temperatureinwirkung des Schweißguts auf die Bleche 1a,1b während des Verschweißens und der Verteilung des Schweißguts im Schweißnahtquerschnitt bilden sich am Schweißnahtübergang und an der Schweißnahtwurzel Kerben aus, die als Ausgangspunkt eines Spannungsrisses dienen können. Um etwa die Ermüdungsfestigkeit des zu bewertenden Querschnitts 4 beurteilen zu können wird, wird das an sich bekannte Kerbspannungskonzept herangezogen. Dabei werden die realen Kerben an den Übergängen von den Blechen zum Schweißnahtquerschnitt sowie an der Nahtwurzel im zu bewertenden Querschnitt 4 gemäß der Kerbspannungsmethode mit idealisierten, normierten Kerb-Radien 3 modelliert, in der Abbildung werden dabei die Kerb-Radien 3a am Schweißnahtübergang und der Kerb-Radius 3b in der Schweißnahtwurzel unterschieden.

Es versteht sich dabei von selbst, dass beliebige zu bewertende Querschnitte 4 von unterschiedlichen Bauteilen 1 denkbar sind, bei der eine oder mehr als eine Schweißnaht 2 zwei oder mehr als zwei Komponenten, etwa Bleche, miteinander verbindet.

Um nun die Kerbspannung σ_{K} im zu bewertenden Querschnitt 4 berechnen zu können, ist es gemäß dem Stand der Technik üblich ein FEM-, Finite Elemente Methoden, Modell zu bilden, in dem Randbedingungen festgelegt werden, um über die sich ausbildenden Reaktionskräfte und den physikalischen Zusammenhang zwischen Verschiebung und Spannung die auftretenden Kerbspannungen σ_{K} zu berechnen. Figur 2 zeigt dabei rein exemplarisch den großen Einfluss den die Wahl der Randbedingungen auf die Reaktionskräfte F an den Schnittufern und den Biegemomentverlauf B haben, obwohl jeweils die gleiche Kraft F auf das Stegblech 1b wirkt:
In der linken Abbildung ist das Gurtblech 1a auf einer Seite fest eingespannt, wobei der linke Abschnitt komplett biegemomentfrei ist und ein Einspannmoment M am Ende des rechten Abschnitts vorherrscht.

In der mittleren Abbildung werden beide Enden des Gurtblechs 1a durch ein Auflager gehalten, wobei die Auflagerkräfte jeweils der Hälfte der Kraft F entsprechen und die Enden des Gurtblechs 1a momentenfrei sind.

In der rechten Abbildung sind beide Enden des Gurtblechs 1a fest eingespannt. Daraus resultiert der abgebildete Biegemomentverlauf B mit den beiden Einspannmomenten M an den Enden.

Wie die drei Abbildungen verdeutlichen, beeinflusst die Wahl der Randbedingungen den Kraftfluss durch den zu bewertenden Querschnitt 4 maßgeblich, obwohl dieselbe Kraft F auf das Stegblech 1b wirkt. Damit hängen aber naturgemäß auch die berechenbaren Kerbspannungen σ_{K} im zu bewertenden Querschnitt 4 direkt von den definierten Randbedingungen ab. Das große Problem dabei besteht jedoch darin, dass sich die Randbedingungen für den tatsächlichen Lastfall nicht realitätsgetreu abbilden lassen, sondern vielmehr durch den Anwender eine Annahme über die Randbedingungen getroffen werden muss, bevor überhaupt die Kerbspannungen σ_{K} berechnet werden können. Diese Annahme hat jedoch, wie oben gezeigt, große Auswirkungen auf das Ergebnis der Berechnungen, wobei der Einfluss der gewählten Randbedingungen nicht quantifizierbar ist.

Erfindungsgemäß wird daher die Kerbspannung σ_{K} mittels der Inertia-Relief Methode berechnet, bei der keine Randbedingungen definiert werden müssen und das Ergebnis der Berechnung der Kerbspannungen σ_{K} damit quasi analytisch exakt ausfällt.

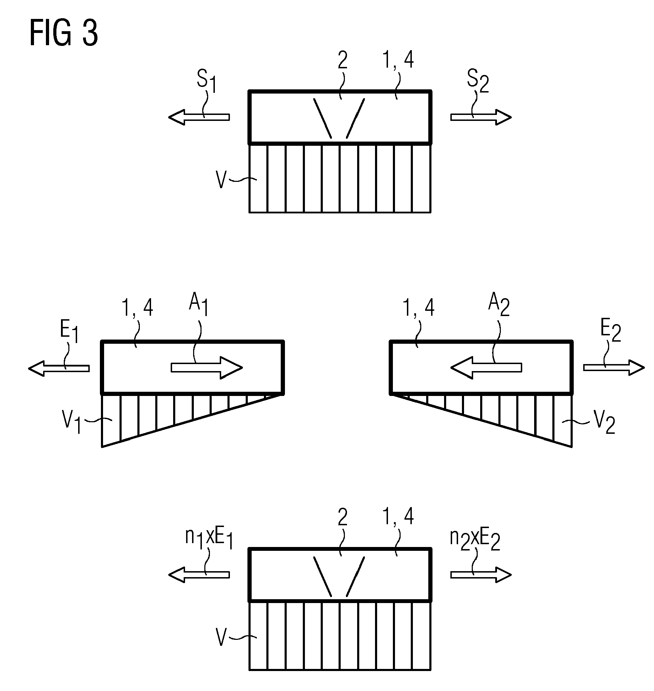

Die prinzipielle Funktionsweise des erfindungsgemäßen Verfahrens wird in Figur 3 schematisch dargestellt:
Dargestellt ist ein zu bewertender Querschnitt 4 eines Bauteils 1, der rein exemplarisch zur Verdeutlichung der Inertia-Relief Methode ausgewählt ist und eine Schweißnaht 2 aufweist. Es versteht sich von selbst, dass sich das nachfolgend beschriebene Verfahren auch auf den T-förmigen Querschnitt 4 aus den Figuren 1 und 2 bzw. auf einen beliebigen Querschnitt 4 mit zwei oder mehreren Schweißnähten 2 und/oder mehr als zwei Bauteilkomponenten angewendet werden kann. Der Übersichtlichkeit halber wurde auf das Einzeichnen der Kerb-Radien 3 verzichtet, die nach dem Kerbspannungskonzept ausgewählt sind (siehe Fig. 1).

Die oberste Figur zeigt den zu bewertenden Querschnitt 4, der mit einer ersten Schnittlast S₁ und einer zweiten Schnittlast S₂ belastet ist, wobei beide Schnittlasten S₁,S₂ als Schnittkräfte ausgebildet sind. Die beiden Schnittlasten S₁,S₂ spiegeln den Belastungszustand des zu bewertenden Querschnitt 4 wider und wirken als definierte äußere Belastung. Im vorliegenden Fall ist der Belastungszustand durch zwei an den beiden Schnittufern angreifende Schnittkräfte dargestellt, im Allgemeinen sind natürlich auch mehr als zwei Schnittufer, mehr als eine Schnittlast S pro Schnittufer oder äußere Kräfte die, gegebenenfalls auch zusätzlich, auf den zu bewertenden Querschnitt 4 wirken, denkbar, die den Belastungszustand des zu bewertenden Querschnitts 4 darstellen.

Aus dieser definierten Last resultiert ein Spannungsverlauf V, auf dem die Spannungsberechnung, insbesondere die Berechnung der Kerbspannungen σ_{K}, basiert. Bei dem abgebildeten Belastungszustand bildet sich ein rechteckiger Spannungsverlauf V aus, wobei sich der zu bewertende Querschnitt 4 in einem quasi-statischen Gleichgewichtszustand befindet, da sich die beiden Schnittlasten S₁,S₂ gegenseitig aufheben. In anderen Worten befindet sich der zu bewertende Querschnitt 4 in Ruhe. Um die nachfolgenden Verfahrensschritte mittels eines Computers durchführen zu können ist es vorteilhaft, wenn der zu bewertende Querschnitt 4 durch ein Querschnittsmodell modelliert ist. Bei dem Querschnittsmodell kann es sich beispielsweise um ein FEM-Modell handeln, bei dem die Geometrie des zu bewertenden Querschnitts durch ein Gitternetz mit einer Vielzahl an Knotenpunkten modelliert wird und in jedem Kontenpunkt ein Spannungstensor speicherbar bzw. berechenbar ist.

Die beiden Darstellungen in der Mitte von Figur 3 zeigen nun unter anderem das Wirkungsprinzip der Inertia-Relief Methode: Anstatt, wie in Fig. 2 erläutert, Randbedingungen festzulegen und die Verschiebungen zu berechnen, wird der zu bewertende Querschnitt jeweils mit nur einer einzelnen Einheitslast E belastet und ein Beschleunigungsfeld A als Systemantwort auf die Einheitslast E berechnet. In anderen Worten befindet sich der zu bewertende Querschnitt 4 in der linken und rechten mittleren Abbildung nicht wie in der oberen Abbildung in Ruhe, sondern befindet sich in einem Zustand der konstanten Beschleunigung. Während das Beschleunigungsfeld A zum besseren Verständnis der Methode als Pfeil dargestellt ist, versteht es sich von selbst, dass das Beschleunigungsfeld A als Beschleunigungsvektoren und/oder Beschleunigungstensoren in den einzelnen Knotenpunkten des Querschnittsmodells berechnet und dargestellt werden kann.

Theoretisch wäre es natürlich möglich, die Beschleunigungsfelder A direkt für die entsprechenden Schnittlasten S zu berechnen. Erfindungsgemäß ist jedoch vorgesehen, dass die Berechnung der Beschleunigungsfelder A von der tatsächlichen Belastung des zu bewertenden Querschnitts 4 entkoppelt ist. Während in der vorliegenden vereinfachten Prinzip-Darstellung die erste Schnittkraft S₁ und die erste Einheitskraft E₁ bzw. die zweite Schnittkraft S₂ und die zweite Einheitskraft E₂ gleichgerichtet sind und sich nur betragsmäßig unterscheiden, kann in einem allgemeinen zweidimensionalen Belastungszustand die tatsächliche Belastung durch zwei linear unabhängige Einheitskräfte und ein Einheitsmoment dargestellt werden.

Durch die Entkoppelung der tatsächlich auf den zu bewertenden Querschnitt 4 wirkenden Last und der dem jeweiligen Beschleunigungsfeld A zugrunde liegende Einheitslast E wird erfindungsgemäß ein Sub-Modell erstellt, welches es ermöglicht, die Ergebnisse der Inertia-Relief Methode in einfacher Art und Weise für die Berechnung einer Vielzahl an unterschiedlichen Belastungsfälle anwenden zu können. Die Erstellung des Sub-Modells soll in der Folge kurz erläutert werden:
In der linken mittleren Abbildung ist der zu bewertende Querschnitt 4 mit der ersten Einheitslast E₁ belastet und das erste Beschleunigungsfeld A₁ wird computergestützt als Systemantwort des zu bewertenden Querschnitts 4 auf die durch die erste Einheitslast E₁ bedingte Beschleunigung berechnet. Daraus resultiert ein erster Spannungsverlauf V₁ der dreiecksförmig ausgebildet ist und sein Maximum am Angriffspunkt der ersten Einheitslast E₁, also am ersten Schnittufer, aufweist. Auf Basis dieses ersten Beschleunigungsfelds A₁ wird danach eine erste Einheits-Teil-Kerbspannung σ_{TE}(E₁) aufgrund der ersten Einheitslast E₁ berechnet, die insbesondere für die nicht dargestellten Kerb-Radien 3 berechnet werden. Beispielsweise kann die erste Einheits-Teil-Kerbspannung σ_{TE}(E₁) einen skalaren Wert oder eine Spannungsvektor oder einen Spannungstensor für jeden die Kerb-Radien 3 ausbildenden Knotenpunkt des Querschnittsmodells umfassen.

In analoger Art und Weise wird in der rechten mittleren Abbildung das zweite Beschleunigungsfeld A₂ als Systemantwort auf die zweite Einheitslast E₂ berechnet, wobei sich wiederum ein dreiecksförmiger zweiter Spannungsverlauf V₂ ausbildet, der sein Maximum am zweiten, dem ersten gegenüberliegenden, Schnittufer aufweist. Nachfolgend wird eine zweite Einheits-Teil-Kerbspannung σ_{TE}(E₂) aufgrund der zweiten Einheitslast E₂, analog zur oben beschriebenen Berechnung der ersten Einheits-Teil-Kerbspannung σ_{TE}(E₁), berechnet.

Während die Berechnung der Einheits-Teil-Kerbspannung σ_{TE} im vorliegenden Beispiel damit beendet ist, müssten, um einen allgemeinen Belastungszustand darstellen zu können, noch an jedem Schnittufer die Einheits-Teil-Kerbspannungen σ_{TE} aufgrund einer linear unabhängigen, vorzugsweise vertikal gerichteten, Einheitskraft und eines Einheitsmoments in analoger Art und Weise berechnet werden. Damit ist die Erstellung des Sub-Modells abgeschlossen.

Um nun die Kerbspannung σ_{K} aufgrund der tatsächlichen Belastungssituation des zu bewertenden Querschnitts 4 berechnen zu können, ist es nunmehr notwendig, die Einheits-Teil-Kerbspannungen σ_{TE} des Sub-Modells derart anzupassen, dass sie die Belastung des zu bewertenden Querschnitts 4 durch die Schnittlasten S widerspiegelt. Da die Einheits-Teil-Kerbspannungen σ_{TE} auf jeweils einer Einheitslast E basieren, müssen also nur die Schnittlasten S durch die Einheitslasten E dargestellt werden. Dazu wird für jede Einheitslast E ein entsprechender Linearkombinations-Faktor n berechnet. So lässt sich die erste Schnittlast S₁ durch Multiplikation der ersten Einheitslast E₁ mit einem ersten Linearkombinations-Faktor n₁ darstellen und die zweite Schnittlast S₂ durch Multiplikation der zweiten Einheitslast E₂ mit einem zweiten Linearkombinations-Faktor n₂. Da die Einheits-Teil-Kerbspannung σ_{TE}(E₁), σ_{TE}(E₂) direkt proportional zu den ihnen zugrunde liegenden Einheitslasten E₁,E₂ sind, lassen sich mithilfe der Linearkombinations-Faktor n₁,n₂ auch die Teil-Kerbspannungen σ_{T1},σ_{T2} berechnen, wobei die erste Teil-Kerbspannung σ_{T1} aus der Multiplikation der ersten Einheits-Teil-Kerbspannung σ_{TE}(E₁) mit dem ersten Linearkombinations-Faktor n₁ und die zweite Teil-Kerbspannung σ_{T2} aus der Multiplikation der zweiten Einheits-Teil-Kerbspannung σ_{TE}(E₂) mit dem zweiten Linearkombinations-Faktor n₂ resultiert. Die tatsächliche Kerbspannung σ_{K} wird schlussendlich durch die Superposition der beiden Teil-Kerbspannungen σ_{T1}, σ_{T2} berechnet. Die beiden Beschleunigungsfelder A heben sich dabei bei der Superposition gegenseitig auf, sodass sich der zu bewertende Querschnitt 4 nach der Linearkombination und Superposition wieder in Ruhe befindet.

Wie die untere Abbildung in Figur 3 zeigt, entspricht der aus der Linearkombination der Einheitslasten E resultierende Spannungsverlauf V dem realen Spannungsverlauf V der oberen Abbildung ohne dass bei der Berechnung eine Annahme über die Randbedingungen getroffen werden musste. Somit spiegeln die mit Hilfe des Sub-Modells berechneten Kerbspannungen σ_{K} den tatsächlichen Kraftfluss im zu bewertenden Querschnitt 4 wider und können so als analytische Lösung des mechanischen Problems gesehen werden.

Ein weiterer großer Vorteil des erfindungsgemäßen Verfahrens liegt nun darin, dass die komplexe Berechnung der Einheits-Teil-Kerbspannungen σ_{TE} nur einmal bei der Erstellung des Sub-Modells notwendig ist und für die Berechnung der Kerbspannungen σ_{K} für eine beliebige Anzahl an Lastfällen lediglich die weit weniger rechenintensiven Schritte der Bestimmung der Linearkombinations-Faktoren sowie die Linearkombination der Einheits-Teil-Kerbspannungen σ_{TE} und schließlich die Superposition derselben notwendig ist.

Um zu verhindern, dass Sub-Modelle für denselben zu bewertenden Querschnitt mehrmals berechnet werden müssen, werden die Sub-Modelle in einem nicht temporären Speicher abgespeichert und mit Querschnitts-Geometrie-Daten, wie der Schweißnahtgeometrie oder der geometrischen Form des zu bewertenden Querschnitts inklusive der Position der zumindest einen Schweißnaht im Querschnitt, verknüpft. Somit kann vor der Erstellung eines Sub-Modells geprüft werden, ob bereits ein Sub-Modell für den zu bewertenden Querschnitt im Speicher gespeichert ist. Wenn dies der Fall ist, kann das Sub-Modell aus dem Speicher geladen werden, anstatt das Sub-Modell neu zu erstellen.

Um zu überprüfen, ob das Sub-Modell korrekt erstellt ist und die Linearkombination der Einheitslasten tatsächlich den Belastungszustand widerspiegelt, wird vor der Berechnung der Kerbspannungen σ_{K} überprüft, ob die Summe der linearkombinierten Einheitslasten E sich in einem Gleichgewichtszustand befinden. Wenn kein Gleichgewichtszustand vorliegt, so muss die Berechnung unterbrochen werden und der Anwender eine Mitteilung erhalten, dass ein Berechnungsfehler vorliegt und die Eingaben zu überprüfen sind.

Obwohl die Erfindung in Detail durch oben dargestellte bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden ohne den Schutzumfang der Erfindung zu verlassen.

### Bezugszeichenliste:

- 1: Bauteil
1a Gurtblech
1b Stegblech
- 2: Schweißnaht
- 3: Kerb-Radius
3a Kerb-Radius am Schweißnahtübergang
3b Kerb-Radius in der Schweißnahtwurzel
- 4: zu bewertender Querschnitt

## Patentansprüche

1. Verfahren, durchgeführt mittels eines Computers, zur Berechnung von Kerbspannungen (σ_{K}) an einem zu bewertenden Querschnitt eines zumindest eine Schweißnaht (2) aufweisenden Bauteils (1),
wobei in dem zu bewertenden Querschnitt (4) zumindest eine lokale Kerbe und/oder Wurzelkerbe der zumindest einen Schweißnaht (2) durch einen nach dem Kerbspannungskonzept ausgewählten Kerb-Radius (3) modelliert wird,
wobei der zu bewertende Querschnitt (4) mit einer definierten Last beaufschlagt ist,
**dadurch gekennzeichnet, dass**
zur Berechnung der Kerbspannungen (σ_{K}) am Kerb-Radius (3) ein von zumindest einer normierten Einheitslast (E₁,...,E_{n;}
E_{X}) abhängiges Sub-Modell verwendet wird,
wobei zur Erstellung des Sub-Modells folgende Schritte für jede Einheitslast (E_{X}) durchgeführt werden:
- Belasten des zu bewertenden Querschnitts (4) mit der jeweiligen Einheitslast (E_{X}) ohne die Definition von diskreten Einspannungs-Bedingungen für den zu bewertenden Querschnitt (4);
- Ermitteln eines aus der Einheitslast (E_{X}) resultierenden Beschleunigungsfelds (A_{X}) mittels der Inertia-Relief Methode;
- Berechnen einer Einheits-Teil-Kerbspannung (σ_{TE}(E_{X})) aufgrund der Einheitslast (E_{X}) und des ermittelten Beschleunigungsfelds (A_{X});
wobei die Berechnung der Kerbspannung (σ_{K}) mittels des Sub-Modells folgende Schritte umfasst:
- Darstellen des durch die definierte Last bedingten Belastungszustands des zu bewertenden Querschnitts (4) als Linearkombination der zumindest einen Einheitslast (E₁,...,E_{n;} E_{X}) durch Bestimmung eines Linearkombinations-Faktors (n₁...nₙ; n_{X}) für jede Einheitslast (E₁,...,E_{n;} Ex);
- Berechnen von Teil-Kerbspannungen (σ_{T1}, ..., σ_{Tn}; σ_{TX}) durch Multiplikation jeder Einheits-Teil-Kerbspannung (σ_{TE} (E₁) ..., σ_{TE}(Eₙ); σ_{TE}(E_{X})) mit dem der jeweiligen Einheitslast (E₁,...,E_{n;} E_{X}) zugeordneten Linearkombinations-Faktor (n₁...nₙ; nₓ) ;
- Lineare Superposition aller Teil-Kerbspannungen (σ_{T1},...,σ_{Tn}; σ_{TX}).

2. Verfahren nach Anspruch 1, **dadurch gekennzeichnet, dass** der zu bewertende Querschnitt (4) zur Erstellung des Sub-Modells und/oder zur Berechnung der Kerbspannungen (σ_{K}) als Querschnittsmodell abgebildet wird, vorzugsweise mittels eines FEM-, Finite Elemente Methoden, Verfahrens.

3. Verfahren nach Anspruch 1 oder 2, **dadurch gekennzeichnet, dass** der Belastungszustand des zu bewertenden Querschnitts (4) durch an zumindest zwei Schnittufern angreifende Schnittlasten (S₁...Sₘ) dargestellt wird.

4. Verfahren nach Anspruch 3, **dadurch gekennzeichnet, dass** die Art, Richtung und Anzahl der normierten Einheitslasten (E₁,_{...},Eₙ) derart gewählt ist, dass sich zumindest die angreifenden Schnittlasten (S₁...Sₘ) als Linearkombination der Einheitslasten (E₁,...,Eₙ) darstellen lassen.

5. Verfahren nach einem der Ansprüche 1 bis 4, **dadurch gekennzeichnet, dass** die normierten Einheitslasten (E₁,...,Eₙ) als linear unabhängige Einheitskräfte und/oder linear unabhängige Einheitsmomente ausgebildet sind, sodass beliebige Lastzustände als Linearkombination der normierten Einheitslasten (E₁,...,Eₙ) darstellbar sind.

6. Verfahren nach einem der Ansprüche 1 bis 5, **dadurch gekennzeichnet, dass** der zu bewertende Querschnitt (4) normal zur Verlaufsrichtung der zumindest einen Schweißnaht (2) im Bauteil (1) ausgerichtet ist.

7. Verfahren nach einem der Ansprüche 1 bis 6, **dadurch gekennzeichnet, dass** das, insbesondere die Einheits-Teil-Kerbspannungen (σ_{TE}) aufgrund der einzelnen Einheitslasten (E₁,...,Eₙ) umfassende, Sub-Modell nach der Erstellung in einem nicht temporären Speicher gespeichert wird.

8. Verfahren nach Anspruch 7, **dadurch gekennzeichnet, dass** das Sub-Modell Querschnittsgeometrie-Daten zur Identifikation des Sub-Modells umfasst.

9. Verfahren nach Anspruch 8, **dadurch gekennzeichnet, dass** die Querschnitts-Geometrie-Daten zumindest eine der folgenden Informationen enthalten:
Anzahl der einzelnen den zu bewertenden Querschnitt (4) ausbildenden Komponenten (1a...1k), relative Position der Komponenten (1a...1k) zueinander, Dicke der einzelnen Komponenten (1a...1k), Position der zumindest einen Schweißnaht (2) im zu bewertenden Querschnitt (4), Schweißnaht-Typ und/oder Schweißnaht-Querschnitt der jeweiligen Schweißnaht (2).

10. Verfahren nach Anspruch 8 oder 9, **dadurch gekennzeichnet, dass** vor der Erstellung eines neuen Sub-Modells für einen zu bewertenden Querschnitt (4) überprüft wird, ob eines der im Speicher gespeicherten Sub-Modelle dieselben Querschnitts-Geometrie-Daten aufweist wie der zu bewertende Querschnitt (4) des zu erstellenden Sub-Modells.

11. Verfahren nach Anspruch 10, **dadurch gekennzeichnet, dass** das Sub-Modell erstellt wird, wenn die Überprüfung des Speichers kein Ergebnis liefert.

12. Verfahren nach Anspruch 10 oder 11, **dadurch gekennzeichnet, dass** das Sub-Modell aus dem Speicher zur Berechnung der Kerbspannung (σ_{K}) verwendet wird, wenn die Überprüfung ergeben hat, dass die Querschnitts-Geometrie-Daten eines der gespeicherten Sub-Modelle den Querschnitts-Geometrie-Daten des aktuell zu bewertenden Querschnitts (4) entsprechen.

13. Verfahren nach einem der Ansprüche 1 bis 12, **dadurch gekennzeichnet, dass** vor der Berechnung der Teil-Kerbspannungen (σ_{T1},...,σ_{Tn}) und/oder vor der Ausgabe der berechneten Kerbspannung (σ_{K}) eine Plausibilitätsüberprüfung durchgeführt wird und eine Meldung generiert wird, falls die Plausibilitätsprüfung fehlschlägt.

14. Verfahren nach Anspruch 13, **dadurch gekennzeichnet, dass** zur Plausibilitätsprüfung überprüft wird, ob sich die aus der Linearkombination der Einheitslasten (E₁,...,Eₙ) resultierenden Lasten am zu bewertenden Querschnitt (4) in einem Gleichgewichtszustand befinden.

15. Verfahren nach einem der Ansprüche 1 bis 14, **dadurch gekennzeichnet, dass** das erfindungsgemäße Verfahren zur Bewertung der Ermüdungsfestigkeit von Schweißnähten nach dem Kerbspannungskonzept eingesetzt wird, wobei Kerbspannungen (σ_{K}) für eine Vielzahl an unterschiedlichen Belastungszuständen, vorzugsweise mit betragsmäßig und/oder richtungsmäßig unterschiedlichen Schnittlasten (S₁...Sₘ), am zu bewertenden Querschnitt (4) mittels des Sub-Modells ermittelt werden.

16. Verfahren nach Anspruch 15, **dadurch gekennzeichnet, dass** die Kerbspannung (σ_{K}) eine tangentiale Spannungskomponente für einen am Kerb-Radius (3) angeordneten Knotenpunkt des zu bewertenden Querschnitts **(Fehler! Verweisquelle konnte nicht gefunden werden.)** aufweist
oder dass eine tangentiale Spannungskomponente für den Knotenpunkt aus der Kerbspannung (σ_{K}) berechnet wird, wobei die tangentiale Spannungskomponente tangential zum Kerb-Radius (3) ausgerichtet ist,
und dass die tangentiale Spannungskomponente bei der Bewertung der Schweißnähte verwendet wird.

17. Computerprogrammprodukt, welches ein Programm umfasst und direkt in einen Speicher eines Rechners ladbar ist, mit Programm-Mitteln, um alle Schritte des Verfahrens nach einem der Ansprüche 1 bis 16 auszuführen, wenn das Programm vom Rechner ausgeführt wird.
